Europäisches Patentamt

European Patent Office

Office européen des brevets

(19)

(11) **EP 0 833 454 B1**

(12) **EUROPEAN PATENT SPECIFICATION**

(45) Date of publication and mention
of the grant of the patent:
**23.04.2003 Bulletin 2003/17**

(51) Int Cl.7: **H03M 1/74**

(21) Application number: **96830491.5**

(22) Date of filing: **30.09.1996**

(54) **Charge digital-analog converter using insulated gate MOS transistors**

Digital-Analog-Wandler des Ladungstyps mit IG-MOS-Transistoren

Convertisseur numérique-analogique à intégration de charges utilisant des transistors MOS à grille isolée

(84) Designated Contracting States:
**DE FR GB IT**

(43) Date of publication of application:
**01.04.1998 Bulletin 1998/14**

(73) Proprietor: **STMicroelectronics S.r.l.**
**20041 Agrate Brianza (Milano) (IT)**

(72) Inventors:
• **Kramer, Alan**
**20041 Agrate Brianza, Milano (IT)**
• **Canegallo, Roberto**
**15057 Tortona, Alessandria (IT)**
• **Chinosi, Mauro**
**20090 Cologno Monzese, Milano (IT)**
• **Gozzini, Giovanni**
**25035 Palazzolo S/O, Brescia (IT)**
• **Rolandi, Pier Luigi**
**15059 Monleale, Alessandria (IT)**
• **Sabatini, Marco**
**20041 Agrate Brianza, Milano (IT)**

(74) Representative: **Botti, Mario**
**Botti & Ferrari S.r.l.,**
**Via Locatelli, 5**
**20124 Milano (IT)**

(56) References cited:
**US-A- 5 014 055        US-A- 5 162 801**
**US-A- 5 376 935**

• **TECHNICAL DIGEST OF THE INTERNATIONAL ELECTRON DEVICES MEETING, SAN FRANCISCO, DEC. 11 - 14, 1994, no. MEETING 40, 11 December 1994, INSTITUTE OF ELECTRICAL AND ELECTRONICS ENGINEERS, pages 449-452, XP002008451 KRAMER A ET AL: "FLASH-BASED PROGRAMMABLE NONLINEAR CAPACITOR FOR SWITCHED-CAPACITOR IMPLEMENTATIONS OF NEURAL NETWORKS"**

**Description**

The present invention relates to a digital-to-analog converter according to the preamble of Claim 1.

Such converters are widely utilized in the field of circuit electronics as implemented with either discrete or integrated elements. There is abundant literature available on the subject.

For instance, a know prior art solution is disclosed in the US patent No. 5,162,801 concerning a Digital-to-Analog converter including low-noise switched capacitors.

It is the object of this invention to provide a circuit which can be readily integrated and programmed, and exhibits good accuracy.

This object is achieved by a digital-to-analog converter having the features set forth in Claim 1. Further advantageous aspects of the invention are set forth in the subclaims.

By using a plurality of floating gate MOS transistors whose threshold voltage is programmable, as is well known, and which can be activated by the inputs of the converter and operated as charge injection circuits, and a charge integration circuit to which such transistors are connected, a circuit can be provided which is readily integratable using MOS or mixed technology, is programmable, and exhibits an accuracy which can be well controlled, also on account of the transistor programmability.

From A. Kramer et al., "Flash-Based Programmable Nonlinear Capacitor for Switched-Capacitor Implementation of Neural Networks", IEDM Tech. Dig., pages 17.6.1-4, December 1994, a charge injection circuit is known which is based on the use of a floating gate MOS transistor connected as a capacitor, wherein the injected/extracted charge is dependent on the threshold voltage of the transistor and the width of the voltage step supplied to its control terminal.

The article also brings out a limitation of that circuit, namely the fact that floating gate MOS transistors of the standard type have a very high parasitic overlap capacitance which dominates over the channel capacitance. This is a cause of considerable error in the charge injection. One way of partially solving this problem, as suggested in the article, is to use a MOS transistor of a particular type, that is a MOS transistor having its floating gate extended outside the channel area (included between the source and the drain areas) in the vertical direction relative to the channel length, but substantially non-overlapping the source and drain areas. Such a MOS transistor is also known, defined as a non-volatile memory cell, from Patent Application EP 0 661 756 A1. In this way, the channel capacitance is increased with respect to the parasitic capacitance, but not to a sufficient extent to make it negligible.

The invention will be more clearly apparent from the following description, to be read in conjunction with the accompanying drawings, in which:

Figure 1 is a circuit diagram of a converter according to the invention;

Figure 2 illustrates possible characteristics of voltage vs. charge of the floating gate MOS transistors in the circuit of Figure 1;

Figure 3 is a detail view of a modified embodiment of the circuit in Figure 1; and

Figure 4 illustrates possible characteristics of voltage vs charge of the MOS transistors in the circuit of Figure 3.

As is known, floating gate MOS transistors are MOS transistors wherein, in the channel area beneath the control or gate terminal, another gate is provided which is isolated from the former and the channel. The threshold voltage of such transistors depends on the amount of charge present at their floating gate. Several ways of programming these transistors, that is of injecting/extracting charge into/from the floating gate, are known from the literature. In view of the widespread utilization of these transistors in semiconductor digital storage circuits, e.g. of the UV_EPROM, EEPROM, FLASH_EPROM types, reference can be had to the abundant literature on the subject for any enlightenment on technology and circuit design.

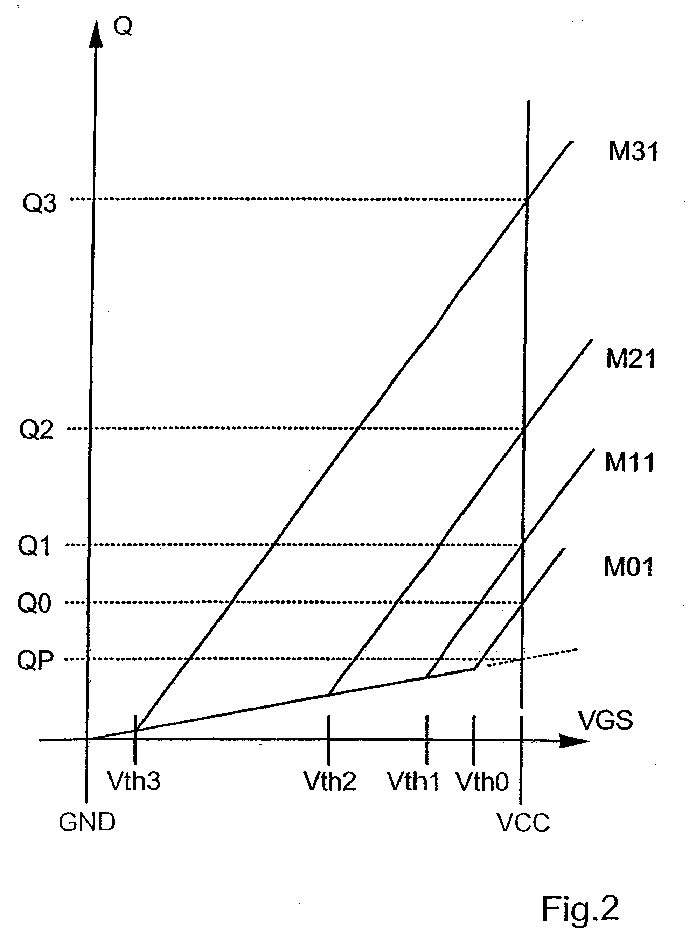

Shown in Figure 2 of the drawings are the characteristics of gate-source VGS voltage vs. charge Q at the control terminal for four floating gate MOS transistors M01, M11, M21, M31, which are capacitor connected and have four different threshold voltages Vth0, Vth1, Vth2, Vth3. These characteristics include a first, shallow section due to parasitic overlap capacitance, and a second, steeper section due both to parasitic capacitance and channel capacitance; the second section starts at the threshold voltage, since at lower voltage values, no channel would occur between the source terminal and the drain terminal.

These characteristics are somewhat idealized, in that phenomena of a higher order contribute to rounding them off and leaving them non-linear.

If the control terminal of such MOS transistors is applied a step-like voltage signal, the amount of injected/extracted charge depends on the initial V1 and final V2 values of the signal, channel capacitance Cch, parasitic capacitance Cpar, and the threshold voltage value Vth, and is given by the formula:

$$(Vth - V1) * Cpar + (V2 - Vth) * (Cpar + Cch).$$

All that is required to change this amount of charge in a simple manner is that the threshold voltage be varied.

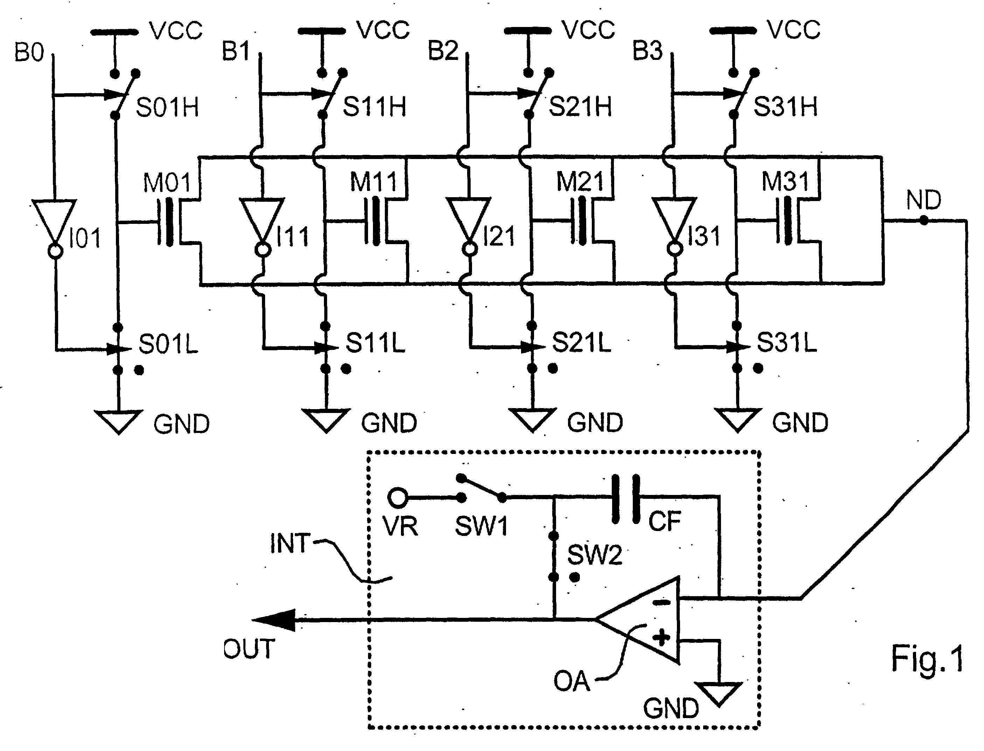

Referring to Figure 1, the digital-to-analog converter of this invention has a plurality of inputs, only four, B0, B1, B2, B3 in the example of Figure 1, for digital signals, and an output OUT for an analog signal, and comprises:

a) a charge integration circuit INT having an input ND and an output coupled to the converter output; and

b) a plurality of floating gate MOS transistors M01, M11, M21, M31 corresponding to the plurality of converter inputs B0, B1, B2, B3, having their source and drain terminals coupled together and to the input ND of the circuit INT, and having control terminals coupleable, under control from the inputs B0, B1, B2, B3, to different references of potential having selected fixed values; and,

c) program circuitry for said floating gate MOS transistors M01, M11, M21, M31, controllably operative to uncouple them from one another and from the integration circuit INT input ND, and to couple them to references of program potential in order to act on the threshold voltage values of the MOS transistors.

For simplicity, all the control terminals may be coupleable alternatively to two references of potential only, specifically the ground GND and the supply VCC. This can be achieved, as shown in Figure 1, by connecting, between the control terminal of the transistor M01 and the supply VCC, a controlled switch S01H, e.g. a traditional type of MOS transistor, and between it and the ground, a controlled switch S01L, e.g. a traditional type of MOS transistor. The input B0 could control the switch S01H directly, and the switch S01L through an inverter I01, for example. The same holds for the transistors M11, M21, M31, the inverters I11, I21, I31, and the switches S11H, S11L, S21H, S21L, S31H, S31L.

However, if the logic levels being supplied to the inputs B0, B1, B2, B3 already correspond naturally to the two values of potential sought, these inputs may be connected directly to the control terminals of the floating gate MOS transistors. In this case, the two references of potential would be external of the converter, in a sense.

In operation, all the control terminals are initially coupled to a first reference, the ground GND in the example of Figure 1, and the integration circuit INT is reset. Thus, the MOS transistors will be fully discharged and the output OUT of the converter will have a selected initial value. Subsequently in operation, the control terminals of the transistors that correspond to inputs at the active logic state are coupled to a second reference, the supply VCC in the example of Figure 1, and the control terminals of the transistors that correspond to inputs at the inactive logic state remain coupled to the first reference. In this way, some MOS transistors will inject/extract charge in amounts that, once added to the input ND and integrated by the circuit INT, will produce at the output OUT an analog signal whose width is tied to the digital signals to the inputs B0, B1, B2, B3.

It often occurs that the inputs of a digital-to-analog converter must have different weights from the output, which weights are typically tied to powers of two. In this case, the value of the threshold voltage of one transistor, e.g. M21, in the plurality that corresponds to one input, e.g. B2, is such that, for a given gate-source voltage step, the total amount of the charge shifted thereat is substantially twice as large as the total amount of charge shifted at the transistor M11 corresponding to the next lower input in weight, B1. This can be obtained by arranging for the value of the threshold voltage of each transistor in the plurality to substantially correspond to the difference between a first constant and the product of a second constant by the power of two equaling the weight of the corresponding input to that transistor.

Figure 2 shows possible characteristics of the transistors M01, M11, M21, M31, with their respective threshold voltages Vth0, Vth1, Vth2, Vth3 and respective shifted charges Q0, Q1, Q2, Q3 for a gate-source voltage step having a corresponding initial value to the ground GND and a final value that corresponds to the supply VCC. The charge QP corresponds to the charge shifted by each transistor independently of its threshold voltage and due to the parasitic capacitance Cpar. In this figure, the amounts of charge shifted, due to the channel capacitance Cch, namely Q0-QP, Q1-QP, Q2-QP, Q3-QP, are tied to the powers of two, whereas the total amounts are only so where the parasitic capacitances Cpar can be regarded as negligible.

A circuit of this type is easy to implement in integrated form, both alone and in combination with further circuitry, as shown best in Figure 1. It is highly versatile in that the type of the conversion is dictated by the values of the threshold voltages of the floating gate MOS transistors, which can be readily changed by "programming". It is accurate because, especially in the integrated implementation, the performance of the MOS transistors is nearly the same, and any types of errors can be corrected by acting on the threshold voltage values.

A further advantage, namely compensation for temperature variations and charge leakage from the floating gates, for example, can be provided by the circuit embodiment discussed below.

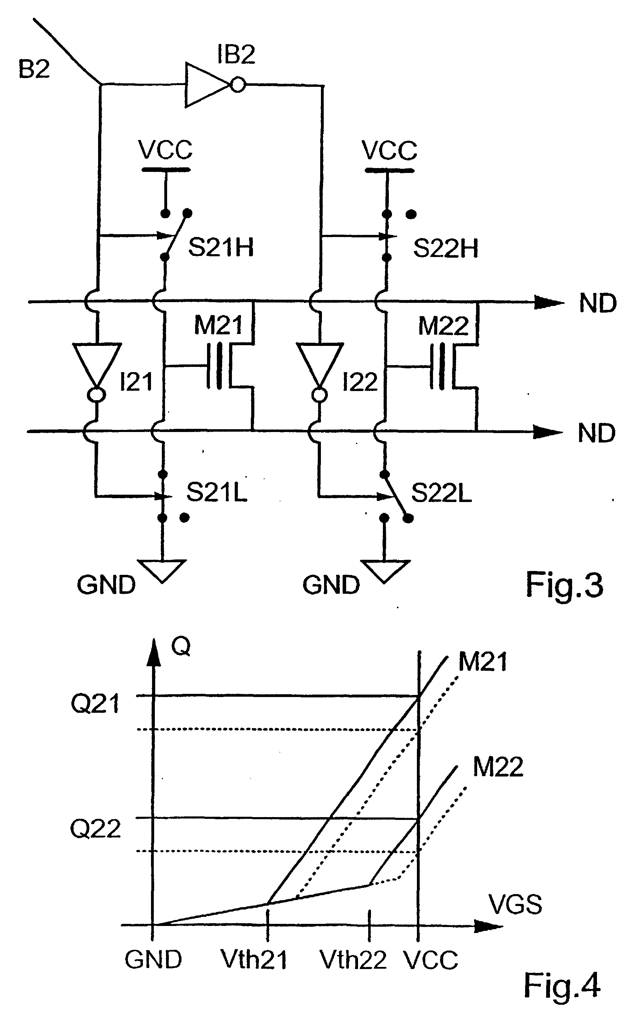

Referring to Figures 1 and 3, a converter according to this invention may also comprise an additional plurality of floating gate MOS transistors M02, M12, M22, M32 corresponding to the first M01, M11, M21, M31, having their source and drain terminals coupled together and to the input ND of the integration circuit INT, and having control terminals coupleable, under control from the inputs, to different references of potential having a selected fixed value, the ground GND and supply VCC, respectively, in the example of Figure 3.

Only one transistor M21 in the first plurality and a corresponding transistor M22 in the additional plurality are shown in Figure 3. The control terminals of both transistors are controlled by the corresponding input B2 in a complementary manner, that is, when the control terminal of transistor M21 is connected to the ground GND, the control terminal of transistor M22 is connected to the supply VCC, and vice versa. The same holds for the other inputs and MOS transistors.

The complementary control is obtained, in Figure 3, by means of an inverter IB2. The control terminal of transistor M21 is connected to the supply VCC, a controlled switch S21H, and the ground GND, a controlled switch S21L, and the input B2 controls the switch S21H directly, and the switch S21L through an inverter I21. The control terminal of transistor M22 is connected to the supply VCC, a controlled switch S22H, and the ground GND, a controlled switch S22L, and the input B2 controls the switch S22H through an inverter IB2, and the switch S22L through an inverter I22 connected in cascade with the inverter IB2.

Shown in Figure 4 is a plot of gate-source voltage VGS vs. charge Q at the control terminal, illustrating possible characteristics of the transistors M21 and M22, along with their respective threshold voltages Vth21 and Vth22, and respective amounts of shifted charge, Q21 and Q22, for gate-source voltage steps whose initial and final values correspond to the ground GND and the supply VCC.

The activation of the transistor pair M21, M22 by the corresponding input B2 has a contribution on the output OUT which is proportional to the difference between Q21 and Q22. It can be seen that any changes in the width of the voltage step VGS and the threshold voltages Vth21 and Vth22 will, so long as equal in magnitude, bear no influence on this contribution. Among the possible sources of changes to the threshold voltages are temperature variations and charge leakage from the floating gates; in addition, any perturbation on either lines connecting the drain terminals to the inputs of the circuit INT would be suppressed likewise.

A suitable simple choice for the values of the threshold voltages of the transistors M02, M12, M22, M32 is the following: all substantially identical and higher than the maximum value of the threshold voltages of the transistors M01, M11, M21, M31 of the first plurality; in this way, the net amount of charge shifted by the activated transistor pairs is unaffected by their parasitic capacitance Cpar, provided of course that the transistors are identical at least in each pair.

Furthermore, if the values of the threshold voltages of the transistors M02, M12, M22, M32 in the additional plurality are also lower than the highest of the values of potential of the references, the supply VCC in the example of Figures 3 and 4, the converter will be compensated as mentioned above.

It will be possible, of course, to select the value of the threshold voltage of each transistor of the first plurality such that it will substantially correspond to the difference between a first constant and the product of a second constant by the power of two equaling the weight of the corresponding input to the transistor. In the two last-mentioned cases, however, the reducing effect of the corresponding transistor in the additional plurality on the shifted charge should be taken into account.

The operation of the converter in Figure 3 is similar to that illustrated by Figure 1, with the following addition: at an initial stage of its operation, the control terminals of the transistors in the additional plurality are all coupled to the second reference, and at a subsequent stage of its operation, the control terminals of the transistors in the additional plurality which correspond to inputs at the active logic state are coupled to the first reference, and the control terminals of the transistors in the additional plurality which correspond to inputs at the inactive logic state remain coupled to the second reference.

As previously mentioned, one way of reducing the effect of the parasitic capacitances consists of using MOS transistors having their floating gate extended outside the channel area in the vertical direction relative to the channel length, but substantially without overlapping the source and drain areas.

Finally, a few words should be spent on the charge integration circuit INT.

The circuit INT, shown in Figure 1, comprises an operational amplifier OA having an inverting input connected to the input of the circuit INT, and a noninverting input connected to the ground GND and a capacitor CF, connected thereto in negative feedback relationship between its output and its inverting input; such a circuit could be reset by shorting the two terminals of the capacitor CF; in this way, however, if the amplifier OA is powered, as is to be expected normally, by connection to the same ground GND and the supply VCC, one of the two transistors that make up the output stage of the amplifier OA will be turned off; this results in that, upon restoring the circuit INT to operation, some of the charge injected at its input will be directed to turn the transistor back on, and the circuit INT cannot function as an integrator, which obviously results in conversion errors.

A viable alternative manner of obviating this problem is illustrated by Figure 1. One of the terminals of the capacitor CF is connected to the output of the amplifier OA through a normally closed controlled switch SW2, and to a reference of potential, VR, intermediate to the ground GND and the supply VCC, through a normally open controlled switch SW1. On resetting, switch SW1 is closed and switch SW2 is opened.

To avoid the risk that, on resetting, the output of the amplifier OA may become saturated, it is advantageous to provide the operational amplifier OA with a further feedback connection, active at least during the reset operation.

As mentioned above, the floating gate MOS transistors can be programmed. The digital-to-analog converter of this invention also includes program circuitry for the floating gate MOS transistors, controllably operable to uncouple them from one another and from the input of the integration circuit, and to couple them to references of program potential.

**Claims**

1. A digital-to-analog converter having a plurality of inputs (B0,B1,B2,B3) for digital signals, and an output (OUT) for an analog signal, comprising:

   a) a charge integration circuit (INT) having an input and an output coupled to the converter output; and **characterized by**:

   b) a plurality of floating gate MOS transistors (M01, M11,M21,M31) corresponding to said plurality of converter inputs, having their source and drain terminals coupled all together and to the input (ND) of said circuit (INT), and having control terminals coupleable, under control from the inputs of said plurality, to different references (VCC,GND) of potential having selected fixed values; and,

   c) program circuitry for said floating gate MOS transistors (M01, M11,M21,M31), controllably operative to uncouple them from one another and from the integration circuit (INT) input (ND), and to couple them to references of program potential in order to act on the threshold voltage values of the MOS-transistors.

2. A converter according to Claim 1, wherein two such references of potential are provided, the value of one (GND) corresponding to the ground potential, and the value of the other (VCC) corresponding to the supply potential.

3. A converter according to either Claim 1 or 2, wherein the value of the threshold voltage of each transistor in said plurality corresponds substantially to the difference between a first constant and the product of a second constant by the power of two equaling the weight of the corresponding input to the transistor.

4. A converter according to one of the preceding claims, wherein, at an initial stage of its operation, the control terminals are all coupled together and to a first reference (GND) and said integration circuit is reset, and at a subsequent stage of its operation, the control terminals of the transistors that correspond to inputs at the active logic state are coupled to a second reference (VCC) and the control terminals of the transistors that correspond to inputs at the inactive logic state remain coupled to the first reference (GND).

5. A converter according to one of the preceding claims, further comprising an additional plurality of floating gate MOS transistors (M02,M12,M22,M32) corresponding to the first plurality (M01,M11,M21,M31), having source and drain terminals which are all coupled together and to the input (ND) of said integration circuit, and having control terminals which are coupleable, under control from the inputs in said plurality, to different references (VCC,GND) of potential having selected fixed values.

6. A converter according to Claims 4 and 5, wherein, during said initial stage of its operation, the control terminals of the transistors in said additional plurality are all coupled to said second reference (VCC), and during said subsequent stage of its operation, the control terminals of the transistors in said additional plurality which correspond to inputs at the active logic state are coupled to said first reference (GND) and the control terminals of the transistors in said additional plurality which correspond to inputs at the inactive logic state remain coupled to the second reference (VCC).

7. A converter according to Claim 6, wherein the values of the threshold voltages of the transistors in the additional plurality are all substantially identical and higher than the maximum value of the threshold voltages of the transistors in the first plurality.

8. A converter according to Claim 7, wherein the values of the threshold voltages of the transistors in the additional plurality are also lower than the highest of the values of potential of said first and second references (GND,VCC).

9. A converter according to one of the preceding claims, wherein the MOS transistors have their floating gate extended outside the channel area in the vertical direction relative to the channel length, but substantially without overlapping the source and drain areas.

10. A converter according to one of the preceding claims, wherein said integration circuit (INT) comprises an operational amplifier (OA) and a capacitor (CF), connected thereto in negative feedback relationship, resettable by connection to an intermediate potential (VR) to ground (GND) and supply (VCC).

11. A converter according to Claim 10, wherein said operational amplifier (OA) has a further feedback connection such that, during said reset operation, its output will not become saturated.

**Patentansprüche**

1.  Digital-Analog-Wandler mit einer Mehrzahl von Eingängen (B0,B1,B2,B3) für digitale Signale und einem Ausgang (OUT) für ein analoges Signal, umfassend:

    a) eine Ladungsintegrationsschaltung (INT) mit einem Eingang und einem Ausgang, der an den Wandlerausgang gekoppelt ist; und **gekennzeichnet durch**:

    b) eine Mehrzahl von Schwebegate-MOS-Transistoren (M01,M11,M21,M31), die der Mehrzahl der Wandlereingänge entspricht, deren Source- und Drain-Anschlüsse alle aneinander und an den Eingang (ND) der Schaltung (INT) gekoppelt sind und deren Steueranschlüsse unter der Kontrolle der Eingänge der Mehrzahl an unterschiedliche Potential-Referenzen (VCC,GND) mit ausgewählten Festwerten koppelbar sind; und

    c) einen Programm-Schaltkreis für die Schwebegate-MOS-Transistoren (M01,M11,M21,M31), der dahingehend steuerbar wirksam ist, dass er sie voneinander und vom Integrationsschaltungs(INT)-Eingang (ND) entkoppeln und sie an Referenzen des Programmpotentials koppeln kann, um auf die Schwellenspannungswerteder MOS-Transistoren einzuwirken.

2.  Wandler nach Anspruch 1, wobei zwei solche Potential-Referenzen zur Verfügung gestellt werden, wobei der Wert des einen (GND) dem Massepotential entspricht und der Wert des anderen (VCC) dem Versorgungspotential entspricht.

3.  Wandler nach Anspruch 1 oder 2, wobei der Wert der Schwellenspannung jedes Transistors in der Mehrzahl im wesentlichen der Differenz zwischen einer ersten Konstante und dem Produkt einer Konstante zum Quadrat entspricht, die gleich dem Gewicht des entsprechenden Eingangs am Transistor ist.

4.  Wandler nach einem der vorhergehenden Ansprüche, wobei in einem Anfangsstadium seines Betriebs die Steueranschlüsse alle aneinander und an eine erste Referenz (GND) gekoppelt sind und die Integrationsschaltung zurückgesetzt ist und in einem nachfolgenden Stadium seines Betiebs die Steueranschlüsse der Transistoren, die Eingängen im aktiven logischen Zustand entsprechen, an eine zweite Referenz (VCC) gekoppelt sind und die Steueranschlüsse der Transistoren, die Eingängen im inaktiven logischen Zustand entsprechen, an die erste Referenz (GND) gekoppelt bleiben.

5.  Wandler nach einem der vorhergehenden Ansprüche, weiter umfassend eine zusätzliche Mehrzahl von Schwebegate-MOS-Transistoren (M02,M12,M22,M32), die der ersten Mehrzahl (M01,M11,M21,M31) entsprechen und Source- und Drain-Anschlüsse aufweisen, die alle aneinander und an den Eingang (ND) der Integrationsschaltung gekoppelt sind, und die Steueranschlüsse aufweisen, welche unter der Kontrolle der Eingänge in der Mehrzahl an unterschiedliche Potential-Referenzen (VCC,GND) mit ausgewählten Festwerten koppelbar sind.

6.  Wandler nach Anspruch 4 und 5, wobei während der Anfangsstadium seines Betriebs die Steueranschlüsse der Transistoren in der zusätzlichen Mehrzahl alle an die zweite Referenz (VCC) gekoppelt sind und während der nachfolgenden Stadium seines Betriebs die Steueranschlüsse der Transistoren in der zusätzlichen Mehrzahl, die den Eingängen im aktiven logischen Zustand entsprechen, an die erste Referenz (GND) gekoppelt sind und die Steueranschlüsse der Transistoren in der zusätzlichen Mehrzahl, die den Eingängen im inaktiven logischen Zustand entsprechen, an die zweite Referenz (VCC) gekoppelt bleiben.

7.  Wandler nach Anspruch 6, wobei die Werte der Schwellenspannungen der Transistoren in der zusätzlichen Mehrzahl alle im wesentlichen identisch und höher als der maximale Wert der Schwellenspannungen der Transistoren in der ersten Mehrzahl sind.

8.  Wandler nach Anspruch 7, wobei die Werte der Schwellenspannungen der Transistoren in der zusätzlichen Mehrzahl auch niedriger sind als der höchste der Werte des Potentials der ersten und zweiten Referenz (GND,VCC) sind.

9.  Wandler nach einem der vorhergehenden Ansprüche, wobei die MOS-Transistoren ihr Schwebegate außerhalb des Kanalbereichs in vertikaler Richtung bezüglich der Kanallänge ausgedehnt haben, aber im wesentlichen ohne die Source- und Drain-Bereiche zu überlappen.

10. Wandler nach einem der vorhergehenden Ansprüche, wobei die Integrationsschaltung (INT) einen Operationsverstärker (OA) und einen Kondensator (CF) umfasst, der damit in negativer Rückkopplung verbunden ist, rücksetzbar durch Verbindung mit einem Zwischenpotential (VR) an die Masse (GND) und die Versorgung (VCC).

11. Wandler nach Anspruch 10, wobei der Operationsverstärker (OA) eine weitere Rückkopplungsverbindung aufweist, so dass während des Rücksetzbetriebs sein Ausgang nicht gesättigt wird.

## Revendications

1. Convertisseur numérique-analogique ayant un ensemble d'entrées (B0, B1, B2, B3) pour des signaux numériques, et une sortie (OUT) pour un signal analogique, comprenant :

   a) un circuit de charge intégré (INT) ayant une entrée et une sortie couplées à la sortie du convertisseur ; et **caractérisé par** :

   b) un ensemble de transistors MOS à grille flottante (M01, M11, M21, M31) correspondant audit ensemble d'entrées du convertisseur, dont les bornes de source et de drain sont toutes couplées entre elles et à l'entrée (ND) dudit circuit (INT), et dont les bornes de commande, commandées par les entrées dudit ensemble, sont couplables aux différents potentiels de référence (VCC, GND) ayant des valeurs fixées sélectionnées ; et,

   c) un circuit de programmation pour lesdits transistors MOS à grille flottante (M01, M1I, M21, M31), pouvant, sur commande, les découpler les uns des autres, ainsi que de l'entrée (ND) du circuit intégré (INT), et les coupler aux potentiels de programmation afin d'agir sur les valeurs de la tension de seuil des transistors MOS.

2. Convertisseur selon la revendication 1, où deux références de potentiel de ce type sont fournies, la valeur de l'une (GND) correspondant au potentiel de la masse, et la valeur de l'autre (VCC) correspondant au potentiel d'alimentation.

3. Convertisseur selon les revendications 1 ou 2, où la valeur de la tension de seuil de chaque transistor dans ledit ensemble correspond en grande partie à la différence entre une première constante et le produit d'une deuxième constante par la puissance de deux équivalent au poids de l'entrée correspondante du transistor.

4. Convertisseur selon l'une des revendications précédentes, où, à une étape initiale de son fonctionnement, les bornes de commande sont toutes couplées entre elles et à une première référence (GND), où ledit circuit intégré est réinitialisé, et où, à une étape suivante de son fonctionnement, les bornes de commande des transistors qui correspondent aux entrées à l'état logique actif sont couplées à une deuxième référence (VCC) et les bornes de commande des transistors qui correspondent aux entrées à l'état logique inactif restent couplées à la première référence (GND).

5. Convertisseur selon l'une des revendications précédentes, comprenant en plus un ensemble supplémentaire de transistors MOS à grille flottante (M02, M12, M22, M32) correspondant au premier ensemble (M01, M11, M21, M31), dont les bornes de source et de drain sont toutes couplées entre elles et à l'entrée (ND) dudit circuit intégré, et dont les bornes de commande, commandées par les entrées dans ledit ensemble, sont couplables aux différentes références (VCC, GND) de potentiel ayant des valeurs fixées sélectionnées.

6. Convertisseur selon les revendications 4 et 5, où, pendant ladite étape initiale de son fonctionnement, les bornes dé commande des transistors dans ledit ensemble supplémentaire sont toutes couplées à ladite deuxième référence (VCC), et où, pendant ladite étape suivante de son fonctionnement, les bornes de commande des transistors dans ledit ensemble supplémentaire correspondant aux entrées à l'état logique actif sont couplées à ladite première référence (GND) et les bornes de commande des transistors dans ledit ensemble supplémentaire correspondant aux entrées à l'état logique inactif restent couplées à la deuxième référence (VCC).

7. Convertisseur selon la revendication 6, où les valeurs des tensions de seuil des transistors dans l'ensemble supplémentaire sont toutes en grande partie identiques et supérieures à la valeur maximale des tensions de seuil des transistors du premier ensemble.

8. Convertisseur selon la revendication 7, où les valeurs des tensions de seuil des transistors de l'ensemble supplémentaire sont également inférieures aux valeurs de potentiel les plus élevées desdites première et deuxième références (GND, VCC).

9. Convertisseur selon l'une des revendications précédentes, où les grilles flottantes des transistors MOS sont prolongées à l'extérieur du canal, à la verticale par rapport à la longueur de ce dernier, mais généralement sans chevaucher les zones de la source et du drain.

10. Convertisseur selon l'une des revendications précédentes, où ledit circuit intégré (INT) comprend un amplificateur opérationnel (OA) et un condensateur (CF), reliés par une boucle de contre réaction négative, réinitialisables par une connexion à un potentiel intermédiaire (VR) à la masse (GND) et à l'alimentation (VCC).

**11.** Convertisseur selon la revendication 10, où ledit amplificateur opérationnel (OA) possède une connexion à une boucle de contre réaction supplémentaire de sorte que sa sortie ne sera pas saturée pendant ladite réinitialisation.

Fig.1

EP 0 833 454 B1

Fig.2

Fig.3

Fig.4